**Europäisches Patentamt**

**European Patent Office**

**Office européen des brevets**

(19)

(11) Veröffentlichungsnummer: **0 058 302**
**B1**

(12) # EUROPÄISCHE PATENTSCHRIFT

(45) Veröffentlichungstag der Patentschrift:
**20.04.88**

(51) Int. Cl.⁴: **G 01 D 3/08,** G 01 D 5/34,
H 03 M 1/22

(21) Anmeldenummer: **82100331.6**

(22) Anmeldetag: **19.01.82**

(54) **Lichtelektrische inkrementale Positioniereinrichtung.**

(30) Priorität: **12.02.81 DE 3104972**

(43) Veröffentlichungstag der Anmeldung:
**25.08.82 Patentblatt 82/34**

(45) Bekanntmachung des Hinweises auf die Patenterteilung:
**20.04.88 Patentblatt 88/16**

(84) Benannte Vertragsstaaten:
**AT CH FR GB IT LI NL SE**

(56) Entgegenhaltungen:
**DE - A - 1 814 785**
**DE - A - 2 540 412**
**DE - A - 2 619 494**
**DE - B - 2 346 091**

(73) Patentinhaber: **Dr. Johannes Heidenhain GmbH,
Nansenstrasse 17, D-8225 Traunreut (DE)**

(72) Erfinder: **Ernst, Alfons, Dipl.-Ing., Traunring 62,
D-8225 Traunreut (DE)**

EP 0 058 302 B1

## Beschreibung

Die Erfindung bezieht sich auf eine lichtelektrische inkrementale Positioniereinrichtung nach dem Oberbegriff des Anspruches 1.

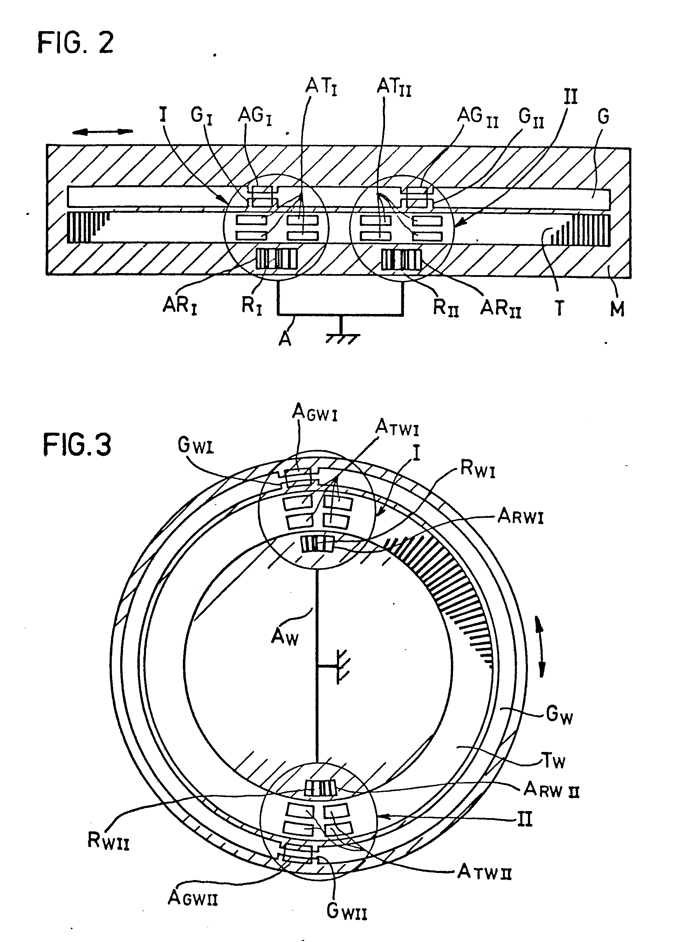

Es sind Positioniereinrichtungen bekannt. In der DE-A1-18 14 785 wird z.B. eine lichtelektrische Längenmesseinrichtung beschrieben, bei der neben der Inkrementalteilung noch eine Referenzmarke vorgesehen ist. In dieser Druckschrift ist die Funktionsweise einer lichtelektrischen inkrementalen Messeinrichtung dargelegt. Ferner ist insbesondere die Funktion und der Aufbau einer Referenzmarke durch die Figur 2 dargestellt.

Gemäss dem Stand der Technik (DE-C1-876 162) ergibt sich an einer Markierung ein besonders günstiger Signalverlauf, wenn die Striche der Strichgruppe in ungleichen Abständen voneinander angeordnet werden. Die Abtastplatte für eine derartige Markierung weist demgemäss ein Ablesefeld auf, das die gleiche Strichverteilung in der Strichgruppe hat wie die Markierung. Bei genauer und vollständiger Überdeckung von Markierung und Ablesefeld wird ein Signal mit ausreichend hohem Nutz-/Störsignalverhältnis erzielt.

In den Druckschriften kommt die Problematik inkrementaler Messsysteme zum Ausdruck: Nach Betriebsunterbrechungen kann nicht ohne weiteres die Anfangslage der Messeinrichtung wiedergewonnen werden. Die Druckschrift (DE-A1-18 14 785) gibt Massnahme an, wie diese Referenz auf möglichst einfache Weise wiedergewonnen werden kann.

In der DE-A1-25 40 412 ist eine inkrementale Messeinrichtung mit mehreren Referenzmarken beschrieben. Aus der Vielzahl von Referenzmarken können eine oder mehrere mit Hilfe von Schaltmitteln ausgewählt und zur Wirkung gebracht werden. Die Referenzmarken-Auswahlschaltmittel sind auf einer Spur verschiebbar angeordnet, die parallel zur Referenzmarkenspur verläuft.

Aus der DE-B2-23 46 091 ist eine inkrementale Messeinrichtung bekannt, die mehrere Abtastfelder in Form von Blenden aufweist. Die Blenden sind zueinander um einen Bruchteil einer Teilungsperiode der abzutastenden Gitterteilung versetzt. Die zueinander versetzten Abtastfelder dienen zur Erkennung von Bewegungs- und Zählrichtung. Referenzmarkierungen sind in dieser Druckschrift nicht vorgesehen.

Die Nachteile der bekannten Messeinrichtungen liegen jedoch darin, dass bei Ausfall der Beleuchtung die Messung gestört wird und dies zu erheblichen Betriebsunterbrechungen mit langen Ausfallzeiten führen kann.

Es ist die Aufgabe der Erfindung, eine inkrementale Positioniereinrichtung zu schaffen, bei der durch den Ausfall der Beleuchtung die momentane Messung nicht spürbar gestört wird und die genauer arbeitet.

Diese Aufgabe wird durch die im Kennzeichen des Anspruches 1 angegebenen Merkmale gelöst.

Der besondere Vorteil der Erfindung liegt in der sicheren lagerichtigen Erzeugung nur eines Referenzsignales mit ausreichendem Nutz-/Störsignalverhältnis, auch wenn die Beleuchtung einer Abtaststelle ausgefallen ist. Der sich ergebende Unterschied im Potential des Signals lässt sich weitestgehend kompensieren.

Die Unteransprüche geben vorteilhafte Weiterbildungen der Erfindung an.

Der Aufbau und die Wirkungsweise der Erfindung werden anhand von Ausführungsbeispielen mit Hilfe der Zeichnungen erläutert.

Es zeigen

Figur 1 eine lichtelektrische Positioniereinrichtung mit zwei Ablegestellen in einer schematischen Seitenansicht,

Figur 2 einen Massstab mit Teilungsspuren und schematisierter Abtastplatte,

Figur 3 eine Winkelmassverkörperung mit Ablesefeldern ähnlich wie in Figur 2

Figur 4 einen schematischen Signalverlauf bei der Abtastung einer Referenzmarke,

Figur 5 einen schematischen Signalverlauf bei Abtastung einer anderen Referenzmarke,

Figur 6 einen Signalverlauf bei korrekter Abtastung zweier Referenzmarken.

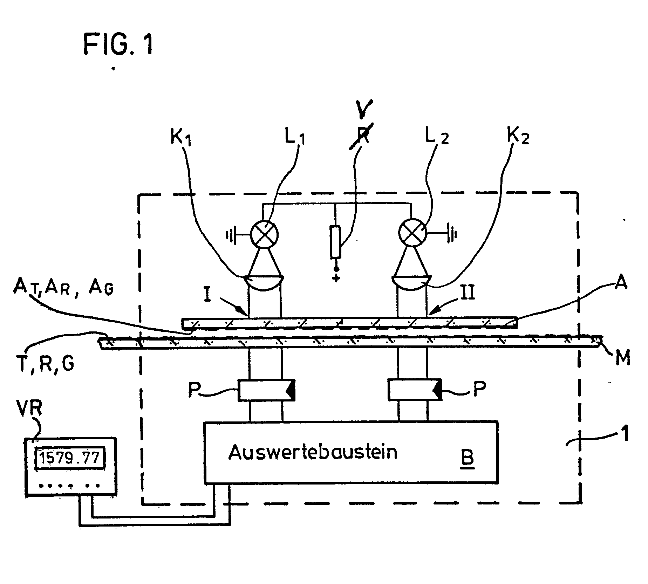

In Figur 1 sind zwei Lampen $L_1$ und $L_2$ in einer Abtastbaueinheit 1 angeordnet. Die Lampen $L_1$ und $L_2$ sind in einem konstanten Abstand voneinander befestigt, werden über einen gemeinsamen Widerstand V betrieben und beleuchten jeweils eine Abtaststelle I bzw. II. Eine Abtastplatte A weist Ablesefelder AT für die Messteilung, AR für die Referenzmarken und AG für Gegentaktsignale auf. Ein Massstab M trägt auf Teilungsspuren eine inkrementale Messteilung T, Referenzmarkierungen R, sowie auf der Gegentaktspur G Verengungen zur Veränderung eines Gegentaktsignales. Die Abtastbaueinheit 1 ist relativ zum Massstab M verschiebbar gelagert. Bei Relativbewegungen zwischen Massstab M und Abtastbaueinheit 1 wird die Abtastplatte A entlang der Teilungsspuren in bekannter Weise geführt. Der von den Lampen $L_1$ und $L_2$ ausgehende Lichtstrom tritt dabei sowohl durch die Abtastplatte A als auch durch den Massstab M. Dabei wird der hindurchtretende Lichtstrom durch die auf beiden Elementen A und M vorhandenen Hell-/Dunkelfelder der Teilungsspuren in bekannter Weise moduliert. Der modulierte Lichtstrom trifft auf lichtempfindliche Elemente P, deren Signale in einem Auswertebaustein B in bekannter Weise aufbereitet und einem Vorwärts-Rückwärtszähler VR zugeführt werden, der den Verschiebeweg digital anzeigt, wobei durch die Referenzmarkensignale eine Eichung bzw. eine Korrektur der inkrementalen Messwerte erfolgt.

In der Beschreibung und in den Figuren wird darauf verzichtet, die Vorwärts-Rückwärtszählung durch vor- oder nacheilende Signale zu erörtern, da diese in zahlreichen Druckschriften ebenso ausführlich dargelegt ist, wie die Eliminierung von Gleichstromanteilen, die sich auf die Signalsymmetrie auswirken könnten. Es sei nur darauf verwiesen, dass zu diesen Zwecken zusätzliche Ablesefelder AT (s. Fig. 2 und 3) und lichtempfindliche Elemente vorzusehen sind, die in bestimmter Zuordnung die Inkrementalteilung abtasten und in bekannter Weise schaltungstechnisch verknüpft werden müssen. Da derartige Massnahmen bei der Darstellung der Erfindung jedoch eher verwirren, wurde auf die weitergehende Darstellung dieser bekannten Einzelheiten verzichtet.

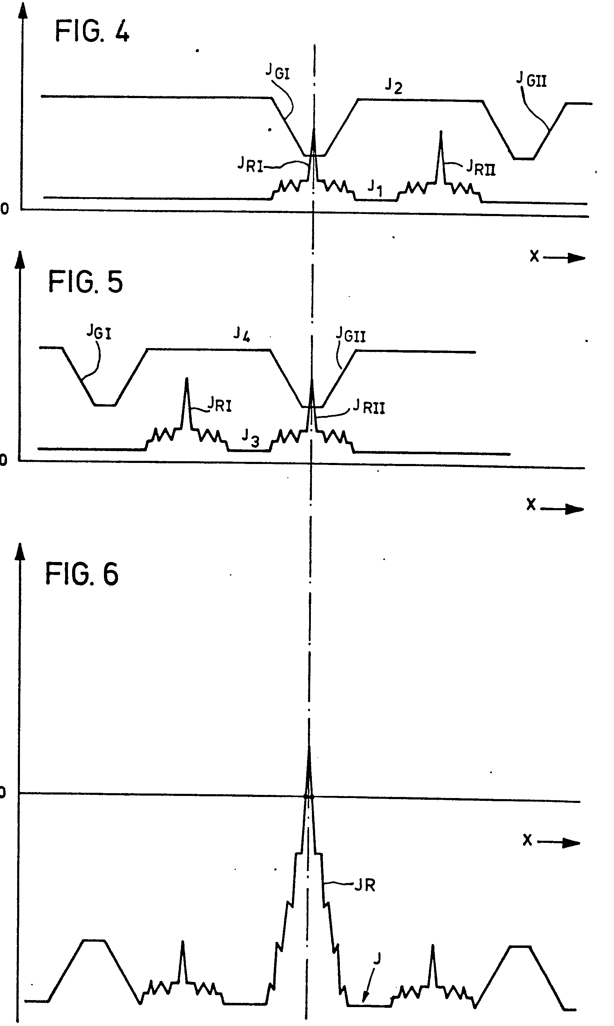

Die Ablesefelder AT, AR und AG müssen exakt um einen bestimmten Betrag zueinander versetzt liegen, da die resultierenden Abtastsignale der jeweiligen Spuren durch analoge Addition zusamlmengefasst werden. Daraus ergibt sich eine höhere Genauigkeit, da eine insgesamt grössere Fläche der Teilung abgetastet wird. Unsauberkeiten der Teilung haben nur noch kleinere Signalfehler zur Folge (siehe auch Figur 4, 5 und 6).

Die Figur 2 zeigt einen Massstab, bei dem auf einer Teilungsspur der Massverkörperung M eine Inkrementalteilung T mit bestimmter Gitterkonstante aufgebracht ist. Eine zweite Teilungsspur weist Referenzmarken $R_I$ und $R_{II}$ auf. Jede der Referenzmarken $R_I$ und $R_{II}$ besteht aus einer Gruppe paralleler Striche. Die Verteilung der Striche innerhalb der jeweiligen Gruppe ist unregelmässig. Von entscheidender Bedeutung ist dabei, dass die Strichverteilung eindeutig ist. Die Verteilung der Striche in beiden Strichgruppen der Referenzmarken muss identisch sein.

Zusätzlich ist eine dritte Spur G zur Erzeugung eines Gegentaktsignals vorgesehen. Diese Spur G weist im Bereich jeder Abtaststelle I bzw. II eine Verengung $G_I$ bzw. $G_{II}$ der Spur G auf, was beim Abtasten des Massstabes jeweils an der Verengung $G_I$ bzw. $G_{II}$ zur Veränderungen des Lichtstromes und damit des Gegentaktsignales führt. Diese Lichtstrommodulation durch die Gegentaktspur G wird mit den Referenzsignalen elektrisch zusammengefasst.

In Figur 3 ist eine entsprechende Winkelmesseinrichtung dargestellt. Gleichartige Elemente wie in der Figur 2 sind durch entsprechende Bezugszeichen mit dem zusätzlichen Index «W» bezeichnet.

In Figur 4 ist der Signalverlauf dargestellt, der sich aus der Abtastung der Referenzmarkenspur und der Gegentaktspur entsprechend der Anordnung gemäss Figur 2 ergibt. Hierbei wird nur die Abtaststelle I betrachtet. Die Massverkörperung M wird dazu in Richtung «X» verschoben. Demgemäss ergibt sich an der Abtaststelle I folgender Ablauf:

Das nicht dargestellte lichtempfindliche Element, das dem Ablesefeld $AG_I$ der Abtastplatte A zugeordnet ist, wird durch die Gegentaktspur G voll beleuchtet und erzeugt das Gegentaktsignal $J_2$. Die Teilungsspur auf der die Referenzmarken $R_I$ und $R_{II}$ liegen, ist noch lichtundurchlässig, dàs dem zugehörigen Ablesefeld $AR_I$ zugeordnete lichtempfindliche Element liefert dementsprechend noch kein Signal ausreichender Höhe. Beim weiteren Verschieben der messverkörperung M entlang der Abtaststelle I wird das Signal $J_2$ zuerst durch die Verengung $G_{II}$ moduliert, wenn diese das Ablesefeld $AG_I$ passiert. Das Signal nimmt während dieses Vorganges ab (s. $JG_{II}$). Bei weiterer Verschiebebewegung passiert die Referenzmarke $R_{II}$ das Ablesefeld $AR_I$ und es wird ein Referenzimpuls $JR_{II}$ erzeugt, der im Diagramm im Signalverlauf $J_1$ dargestellt ist. Da die Absenkung $JG_{II}$ und der Referenzimpuls $JR_{II}$ nicht gleichzeitig auftreten, wird der Referenzimpuls von der Auswerteelektronik nicht erkannt. Bei weiterer Verschiebung der Massverkörperung M decken sich an der Abtaststelle I die Verengung $G_I$ und das Ablesefeld $AG_I$ sowie die Referenzmarke $R_I$ mit dem Ablesefeld $AR_I$. Die Signalmodulation $JG_I$ im Signalverlauf $J_2$ und der Referenzimpuls $JR_I$ im Signalverlauf $J_1$ treten gleichzeitig auf. Die Triggerschaltung in der Auswerteelektronik erkennt den Referenzimpuls und wertet ihn in bekannter Weise aus.

In Figur 5 sind die Signalverläufe $J_3$ und $J_4$ in äquivalenter Weise gezeigt, wenn ausschliesslich die Abtaststelle II betrachtet wird.

Betrachtet man beide Abtaststellen I und II, so ist erkennbar, dass bei dieser Konstellation beide Referenzimpulse $JR_I$ und $JR_{II}$ gleichzeitig auftreten.

Ein Referenzimpuls soll bei einer inkrementalen Messeinrichtung nach Betriebsunterbrechungen ermöglichen, die Bezugslage wieder herzustellen, oder laufend das System eichen. Demgemäss benötigt man einen Referenzimpuls immer bei der gleichen Lagebeziehung von Massverkörperung M und Abtastplatte A. Durch bekannte elektrische Massnahmen lassen sich die vorbeschriebenen zeitgleich bzw. lagegleich auftretenden Referenzimpulse $JR_I$ und $JR_{II}$ analog zusammenfassen, so dass ein resultierendes Referenzsignal JR erzeugt wird, das immer eindeutig bei derselben Lagebeziehung von Massverkörperung und Abtastplatte auftritt.

Ein derartiger Signalverlauf ist in Figur 6 dargestellt. Er ist durch einfache analoge Addition der vorgenannten vier Signale $J_1$, $J_2$, $J_3$, $J_4$ nach der Bedingung $J = (J_1–J_2) + (J_3–J_4)$ gebildet worden.

Bei Deckung von Referenzmarke und zugehörigem Abtastfeld wird in bekannter Weise ein Referenzimpuls hervorgerufen. Bei phasenrichtiger Anordnung von Referenzmarken und Abtastfeldern muss im Augenblick der exaktena Deckung der Markierungen und der Abtastfelder jede der beiden Referenzmarken $R_I$ und $R_{II}$ ein Referenzsignal hervorrufen. Diese Signale werden, wie bereits beschrieben, analog addiert. Es erscheint also nur ein Referenzsignal mit hohem Pegel. Durch die eindeutige Lagezuordnung der Referenzmarke $R_I$ und Ablesefeld $AR_I$ zu der Verengung $G_I$ und deren Ablesefeld $AG_I$ und durch die Lagezuordnung der Referenz $R_{II}$ und Verengung $G_{II}$ sowie deren Ablesefeldern $AR_{II}$ und $AG_{II}$ ist sichergestellt, dass nur das zur jeweiligen Referenzmarke gehörige Abtastfeld ein Referenzsignal mit ausreichend grossem Nutz-/Störsignalverhältnis hervorbringen kann. Werden die Abtastfelder an der jeweils nicht zugehörigen Referenzmarke vorbeibewegt, kann kein zur Auswertung geeignetes Referenzsignal hervorgerufen werden.

Obwohl an verschiedenen Stellen des Massstabes M Referenzmarken $R_I$ und $R_{II}$ angeordnet sind, wird beim Überfahren dieser Marken nur an einer bestimmten Stelle des Massstabes M ein Referenzsignal hervorgerufen. Damit ist der Bezug zur Referenzmarke immer eindeutig. Bei Ausfall einer Beleuchtung $L_1$ oder $L_2$ wird weiterhin an der bestimmten Stelle des Massstabes M ein Referenzsignal hervorgerufen werden. Die zur ausgefallenen Lampe $L_1$ oder $L_2$ gehörige Referenzmarke $R_I$ oder $R_{II}$ kann kein Referenzsignal mehr liefern. Im ungünstigsten Fall wird der Signalpegel des verbleibenden Referenzsignales geringer. Durch richtiges Einstellen der Triggerschwelle kann dieser Nachteil belanglos werden.

Bei Ausfall einer Beleuchtung reduziert sich die Signalhöhe; da die analoge Addition eines Signals entfällt und nur eine Abtaststelle I oder II in Betrieb ist. Eine Erhöhung des Signalpegels kann durch eine Schaltungsmassnahme für den gemeinsamen Betrieb der Lampen $L_1$ und $L_2$ kompensiert werden. Mit Hilfe eines gemeinsamen Vorwiderstandes V werden die Lampen $L_1$ und $L_2$ mit einer reduzierten Spannung betrieben, was eine geringere Helligkeit und damit einen geringeren Fotostrom am Ausgang der lichtempfindlichen Elemente P zur Folge hat. Durch die analoge Addition der Abtastsignale wird jedoch ein Signalpegel erzielt, der höher ist, als der der reduzierten Einzelsignale. Auf den höheren – aus den addierten Signalen gewonnenen – Signalpegel wird die Triggerschwelle im Auswertebaustein B eingestellt. Bei Ausfall einer Lampe $L_1$ oder $L_2$ reduziert sich der Spannungsabfall am Vorwiderstand V und die noch betriebsfähige Lampe $L_1$ oder $L_2$ wird mit der sich ergebenden höheren Spannung betrieben. Dadurch erhöht sich die Beleuchtungsstärke am lichtempfindlichen Element P, was eine direkt Erhöhung des Signalpegels an dessen Ausgang zur Folge hat. Die einschlägigen Kennlinien zeigen, dass die mit höherer Betriebsspannung betriebene verbleibende Lampe ein etwa gleich grosses Abtastsignal liefert, wie das aus Addition gewonnene Abtastsignal. Die Triggerschwelle muss dabei nicht verändert werden. Die Dimensionierung der dabei zusammenwirkenden Elemente liegt im Können eines Durchschnittsfachmanns, so dass darauf nicht näher eingegangen werden muss.

Auch bei einer Winkelmesseinrichtung erhöht sich wie vorbeschrieben durch die erfindungsgemässe Mehrfachabtastung in der vorher beschriebenen Weise die Genauigkeit. Darüber hinaus wird durch eine «Durchmesserablesung» der Exzentrizitätsfehler der Teilung eliminiert. Eine Durchmesserablesung für optische Winkelmesseinrichtungen ist in der DE-C1-24 54 915 bereits beschrieben.

Besonders vorteilhaft lässt sich die Auswerteschaltung so ausgestalten, dass bei Ausfall einer Lampe eine Signaleinrichtung diesen Fehler meldet.

Selbstverständlich lassen sich die Referenzmarken auch auf weiteren parallelen oder konzentrischen Teilungsspuren anordnen und abtasten, wenn die Verwendung der Messeinrichtung dies erfordert.

Die Erfindung ist auch nicht auf lichtelektrische inkrementale Positioniereinrichtungen, die im Durchlichtverfahren arbeiten beschränkt, sondern lässt sich sinngemäss auch bei Einrichtungen verwirklichen, die im Auflichtverfahren arbeiten.

**Patentansprüche**

1. Lichtelektrische inkrementale Messeinrichtung zur Messung der Position zweier relativ zueinander beweglicher Objekte mit einer wenigstens eine inkrementale Messteilung (R, $T_w$), mehrere räumlich zueinander versetzte, jeweils aus einer Gruppe unregelmässig verteilter Striche bestehende Referenzmarken (R, $R_w$) zur Ableitung eines Referenzimpulses (JR) und auf einer Gegentaktspur (G, $G_w$) befindliche einzelnen Referenzmarken zugeordnete Markierungen ($G_I$, $G_{II}$; $G_{wI}$, $G_{wII}$) aufweisenden Massverkörperung (M, $M_w$) und einer Abtastplatte (A, $A_w$) mit mehreren der Messteilung, den Referenzmarken oder den Markierungen zugeordneten Ablesefeldern (AT, AR, AG; $AT_w$, $AR_w$, $AG_w$) zum berührungslosen Abtasten der Massverkörperung (M, $M_w$), dadurch gekennzeichnet, dass die Markierungen ($G_I$, $G_{II}$ bzw. $G_{wI}$, $G_{wII}$) die Form von Verengungen, Schraffuren oder dgl. aufweisen, dass für jede Referenzmarke eine Beleuchtung vorgesehen ist, dass jeder Referenzmarke genau eine Markierung und genau ein Auslesefeld zugeordnet ist, dass die Anordnung der Markierungen auf der Massverkörperung und die Anordnung der ihnen zugeordneten Auslesefelder ($A_{GI}$, $A_{GII}$; $A_{GWI}$, $A_{GWII}$) auf der Abtastplatte die gleichzeitige Deckung irgendeiner der Referenzmarken und der ihr zugeordneten Markierung mit den ihnen jeweils zugeordneten Auslesefeldern nur in einer einzigen Position der Abtastplatte relativ zur Massverkörperung erlaubt.

2. Lichtelektrische inkrementale Messeinrichtung nach Anspruch 1, dadurch gekennzeichnet, dass bei der als Winkelmesseinrichtung ausgebildeten Messeinrichtung die Referenzmarken ($R_{wI}$ und $R_{wII}$) und deren Markierungen ($G_{wI}$ und $G_{wII}$) sowie auf der Abtastplatte ($A_w$) die zugehörigen Ablesefelder ($AR_{wI}$, $AG_{wI}$ und $AR_{wII}$, $AG_{wII}$) diametral angeordnet sind.

3. Lichtelektrische inkrementale Messeinrichtung nach den Ansprüchen 1 und 2, dadurch gekennzeichnet, dass alle Beleuchtungen ($L_1$, $L_2$) über einen gemeinsamen Vorwiderstand (V) betrieben werden.

4. Lichtelektrische inkrementale Messeinrichtung nach den Ansprüchen 1 bis 3, dadurch gekennzeichnet, dass eine Signaleinrichtung vorgesehen ist, die den Ausfall einer Beleuchtung ($L_1$, $L_2$) signalisiert.

**Claims**

1. Photoelectric incremental measuring device for measuring the position of two relatively movable objects, with a scale (M, $M_W$) comprising at least one incremental measurement graduation (T, $T_W$), several reference marks (R, $R_W$) spatially

offset from each other and each consisting of a group of irregularly distributed lines, for deriving a reference pulse (JR), and markings ($G_I$, $G_{II}$; $G_{WI}$, $G_{WII}$) located on a push-pull track (G, $G_W$) and associated with individual reference marks, and with a scanning plate (A, $A_W$) with several reading areas (AT, AR, AG; $AT_W$, $AR_W$, $AG_W$) associated with the measurement graduation, the reference marks or the markings, for contactless scanning of the scale (M, $M_W$), characterised in that the markings ($G_I$, $G_{II}$ or $G_{WI}$, $G_{WII}$) are in the form of constrictions, hatched regions or the like, a light is provided for each reference mark, associated with each reference mark exactly is a marking and a reading area, and the arrangement of the markings on the scale and the arrangement of the reading areas associated therewith ($A_{GI}$, $A_{GII}$; $A_{GWI}$, $A_{GWII}$) on the scanning plate allows simultaneous alignment of any of the reference marks and the marking associated therewith with the reading areas respectively associated therewith, in only one position of the scanning plate relative to the scale.

2. Photoelectric incremental measuring device according to claim 1, characterised in that in the measuring device constructed as an angle measuring device, the reference marks ($R_{WI}$ and $R_{WII}$) and their markings ($G_{WI}$ and $G_{WII}$) and also on the scanning plate ($A_W$) the associated reading areas ($AR_{WI}$, $AG_{WI}$ and $AR_{WII}$, $AG_{WII}$) are arranged diametrically.

3. Photoelectric incremental measuring device according to claims 1 and 2, characterised in that all lamps ($L_1$, $L_2$) are operated via a common series resistor (V).

4. Photoelectric incremental measuring device according to claims 1 to 3, characterised in that there is provided a signalling device which signals failure of a lamp ($L_1$, $L_2$).

**Revendications**

1. Dispositif photoélectrique de mesure incrémentale destiné à mesurer la position de deux objets mobiles l'un par rapport à l'autre, muni d'une échelle de mesure (M, $M_W$) présentant au moins une graduation de mesure (T, $T_W$) incrémentale, plusieurs repères de référence (R, $R_W$) décalés les uns par rapport aux autres dans l'espace, constitués chacun par un groupe de traits répartis de façon irrégulière et destinés à la production d'une impulsion de référence (JR), et des marquages ($G_I$. $G_{II}$; $G_{WI}$, $G_{WII}$) se trouvant sur une piste de cadence antagoniste (G, $G_W$) et associés à des repères de référence individuels; et d'une plaque de balayage (A, $A_W$) comportant plusieurs champs de lecture (AT, AR, AG, $AT_W$, $AR_W$, $AG_W$), attribués à la graduation de mesure, aux repères de référence ou aux marquages, pour le balayage sans contact de l'échelle de mesure (M, $M_W$), caractérisé en ce que les marquages ($G_I$, $G_{II}$ ou $G_{WI}$, $G_{WII}$) possèdent la forme de rétrécissements, de hachures ou analogues, qu'un éclairage est prévu pour chaque repère de référence, qu'à chaque repère de référence est attribué exactement un marquage et exactement un champ de lecture, que la disposition des marquages sur l'échelle de mesure et la disposition des champs de lecture ($A_{GI}$, $A_{GII}$; $A_{GWI}$, $A_{GWII}$) associés sur la plaque de balayage ne permet la coïncidence simultanée d'un quelconque des repères de référence et du marquage associé avec les champs de lecture associés que dans une seule position de la plaque de balayage par rapport à l'échelle de mesure.

2. Dispositif photoélectrique de mesure incrémentale selon la revendication 1, caractérisé en ce que le dispositif de mesure étant réalisé comme dispositif de mesure d'angles, les repères de référence ($R_{WI}$ et $R_{WII}$) et leurs marquages ($G_{WI}$ et $G_{WII}$) ainsi que les champs de lecture ($AR_{WI}$, $AG_{WI}$ et $AR_{WII}$, $AG_{WII}$) associés sur la plaque de balayage ($A_W$) sont disposés diamétralement.

3. Dispositif photoélectrique de mesure incrémentale selon la revendication 1 ou 2, caractérisé en ce que tous les éclairages ($L_1$, $L_2$) fonctionnent avec une résistance série (V) commune.

4. Dispositif photoélectrique de mesure incrémentale selon l'une quelconque des revendications 1 à 3, caractérisé en ce qu'un dispositif de signalisation est prévu qui signale la défaillance d'un éclairage ($L_1$, $L_2$).

## FIG. 1

## FIG. 2

## FIG.3

FIG. 4

$J_{GI}$

$J_2$

$J_{GII}$

$J_{RI}$

$J_{RII}$

$J_1$

0

X ⟶

FIG. 5

$J_{GI}$

$J_4$

$J_{GII}$

$J_{RI}$

$J_{RII}$

$J_3$

0

X ⟶

FIG. 6

0

X ⟶

$J_R$

$J$